# EUROPEAN PATENT APPLICATION

(11) **EP 4 564 395 A1**
(43) Date of publication of application: **04.06.2025**
(21) Application number: 23213322.3
(22) Date of filing: 30.11.2023
(51) Int. Cl.: H01J 37/04, H01J 37/26

(54) **TRANSMISSION ELECTRON MICROSCOPE WITH VARIABLE EFFECTIVE FOCAL LENGTH**

(71) Applicant: FEI Company, Hillsboro, OR 97124-5793 (US)
(72) Inventor: TIEMEIJER, Peter, Eindhoven (NL); BUIJSSE, Bart, Eindhoven (NL)
(74) Representative: Boult Wade Tennant LLP

(57) **Abstract**

A transmission electron microscope (TEM) comprises: a sample holder configured to hold a sample; an electron source configured to provide a beam of electrons towards the sample holder; and a primary lens configured to receive the beam of electrons after leaving the sample holder and to produce a diffraction pattern in a first diffraction plane. The TEM further comprises: an intermediate lens assembly configured to receive the beam of electrons after leaving the primary lens and to form an image of a sample present in the sample holder, wherein the intermediate lens assembly comprises, in sequence, a first lens occupying a first lens region and a second lens occupying a second lens region. The TEM further comprises: a projection assembly configured to receive the image of the sample, the projection assembly occupying a projection assembly region. The TEM further comprises: a first port in a first port plane and a second port in a second port plane. Each of the first port and the second port is configured to receive a wave front manipulating device for manipulating the wave front of the beam. Each of the first port and the second port is located in a different one of: the projection assembly region, the first lens region and the second lens region. A controller is configured to control excitation of the first lens and the second lens. In a first mode the controller is configured to control the first lens and the second lens to direct the diffraction pattern into a second diffraction plane wherein the second diffraction plane is coincident with the first port plane. In a second mode the controller is configured to control the first lens and the second lens to direct the diffraction pattern into a third diffraction plane wherein the third diffraction plane is coincident with the second port plane.

## Description

### Technical Field

The disclosure relates to the field of transmission electron microscopy.

### Background

In a Transmission Electron Microscope (TEM) a beam of electrons produced by an electron source is formed into a beam of electrons illuminating the sample. The sample is very thin, so that part of the electrons pass through the sample unscattered and part of the electrons are scattered by the sample. Some of the scattered electrons are elastically scattered in the sample while others are inelastically scattered, and scattered electrons exit the sample under a different angle than under which they enter the sample. By imaging the sample on a detector, such as a fluorescent screen or a CCD camera, intensity variations in the image plane can be recorded. The intensity fluctuations are in part due to the absorption of some of the scattered electrons in the microscope, and in part due to interference between scattered and unscattered electrons. In thin low-Z materials, such as biological tissues, phase contrast is dominant, and this contrast is mainly caused by interference processes involving elastically scattered electrons. Such materials are usually called phase objects.

The contrast of the image resulting from electrons interfering with each other depends on the angle under which the electrons are scattered and the amount of defocus that is applied. Object features with a specific spatial frequency scatter the beam under a specific angle, the scattering angle being proportional to the spatial frequency. When imaging a phase object exactly in focus, the contrast is close to zero for all spatial frequencies. When applying defocus, then for low spatial frequencies the scattering angle is close to zero and the contrast is still close to zero. For higher spatial frequencies the contrast fluctuates between a positive contrast and a negative contrast, depending on the spatial frequency. This contrast fluctuation is described by the so-named Contrast Transfer Function (CTF), which oscillates like a sine function, starting at zero for zero spatial frequency. As the CTF is close to zero for low spatial frequencies, large structures are poorly visible in the image.

In 1947 Boersch described that the introduction of a phase plate would result in a CTF where low spatial frequencies show a maximum, and large structures can thus better be imaged, see "Über die Kontraste von Atomen im Elektronenmikroskop", H. Boersch, Z. Naturforschung 2A (1947), p. 615-633. Such phase plates have successfully been introduced in TEMs.

A phase plate is a structure that is placed in a plane where the parallel beam illuminating the sample is focused by the objective lens after having passed through the sample, the so called back focal plane. In this plane a diffraction pattern is formed; all unscattered electrons are focused in one point, while scattered electrons reach other positions. The phase plate causes a phase shift between scattered and unscattered electrons of e.g. π/2, thereby converting the sine-like behaviour of the CTF to a cosine-like behaviour.

A phase plate can also be placed in a plane that is conjugate to this first diffraction plane. In such a conjugated plane, the diffraction pattern can be (de)magnified by a factor M. Such a plane has a so called effective focal length f_{eff} which is defined as M times the focal length of the objective lens. It can be advantageous to use a phase plate in such a conjugated plane to create more space for placement of the phase plate and to have freedom in choosing the optimal value of f_{eff}. A large value of f_{eff} usually improves the onset of the cosine-like behaviour ('cut-on frequency') of the CTF.

Phase plates based on CW lasers (Laser Phase Plate, LPP) are currently being explored for use in transmission electron microscopes but are challenging to use in the objective lens region because of the size of the LPP hardware near the electron beam and the risk of contamination of sensitive laser-optical elements near the sample region. Moreover, LPPs require a large value of f_{eff} to have a low enough cut-on frequency. Therefore it is attractive to place an LPP in a plane conjugated to the back focal plane.

In addition to the use of phase plates in TEMs, it is known to incorporate image correctors, which correct the aberrations of the imaging optics, thereby improving the image quality of the TEM.

For example, a correction system may be placed between the objective lens and the projection system of a TEM. The correction system may comprise of a transfer system in the form of a lens doublet, imaging the back-focal plane of the objective lens on a hexapole lens. Said hexapole lens is then imaged on another hexapole lens by a doublet of lenses, and finally an adaptor lens is used to form an image of the object at the entrance of the projection system of the TEM.

There is usually little or no flexibility in terms of the amount of magnification that may be achievable for any of the conjugated diffraction planes in these prior art arrangements. Microscope designs are tailored for achieving one specific magnification.

A phase plate can also incorporate an amplitude mask, to partially or fully block the electron wave at the masked area. Such an amplitude mask may help to improve the phase contrast in the image. A phase plate is thus used to manipulate the electron exit wave front in a way that optimizes the phase contrast at the detector plane, or enables optimal retrieval of phase contrast after some image processing steps.

### Summary of the disclosure

Against this background, there is provided a transmission electron microscope in accordance with claim 1.

In this way, the first diffraction plane can be relayed to a one of a plurality of alternative diffraction planes where a wave front manipulating device, such as a laser phase plate, may be deployed mitigating issues relating to device size or device contamination. Moreover, the first diffraction plane can be magnified and be better matched with the size of the phase shifting area as provided by the wave front manipulating device by choosing an optimal value of the effective focal length. This results in a lower cut-on frequency of the spatial frequencies of the sample that get contrast enhancement by the use of the wave front manipulating device. Furthermore, by providing at least three lenses and two ports configured to receive the wave front manipulating device, a range of different magnifications may be achieved using a single transmission electron microscope operating in different configurations, using different lens excitations.

As such, by providing modest additional hardware in the form of additional ports for a wave front manipulating device, plus associated lens control, there results a more versatile TEM capable of providing a variety of different magnifications of the first diffraction plane.

### Brief description of the drawings

Embodiments of the disclosure are now described with reference to the following drawings, in which:
Figure 1 shows a schematic representation of a transmission electron microscope in accordance with the prior art;
Figure 2 shows a schematic representation of parts of a transmission electron microscope including a phase plate in accordance with the prior art;
Figure 3 shows a schematic representation of parts of a transmission electron microscope in accordance with the prior art which is similar to that of Figure 2 and includes an additional lens;
Figure 4 shows a schematic representation of parts of a transmission electron microscope in accordance with a first aspect of the present disclosure and including a plurality of wave front manipulating device receiving locations;
Figure 5 shows a schematic representation of parts of a transmission electron microscope in accordance with a second aspect of the present disclosure and including correction optics plus a plurality of wave front manipulating device receiving locations;
Figure 6 shows a first mode of operation of the transmission electron microscope in accordance with the first aspect of the present disclosure;
Figure 7 shows a second mode of operation of the transmission electron microscope in accordance with the first aspect of the present disclosure;
Figure 8 shows a third mode of operation of the transmission electron microscope in accordance with the first aspect of the present disclosure;
Figure 9 shows a first mode of operation of the transmission electron microscope in accordance with the second aspect of the present disclosure;
Figure 10 shows a second mode of operation of the transmission electron microscope in accordance with the second aspect of the present disclosure.

### Detailed description

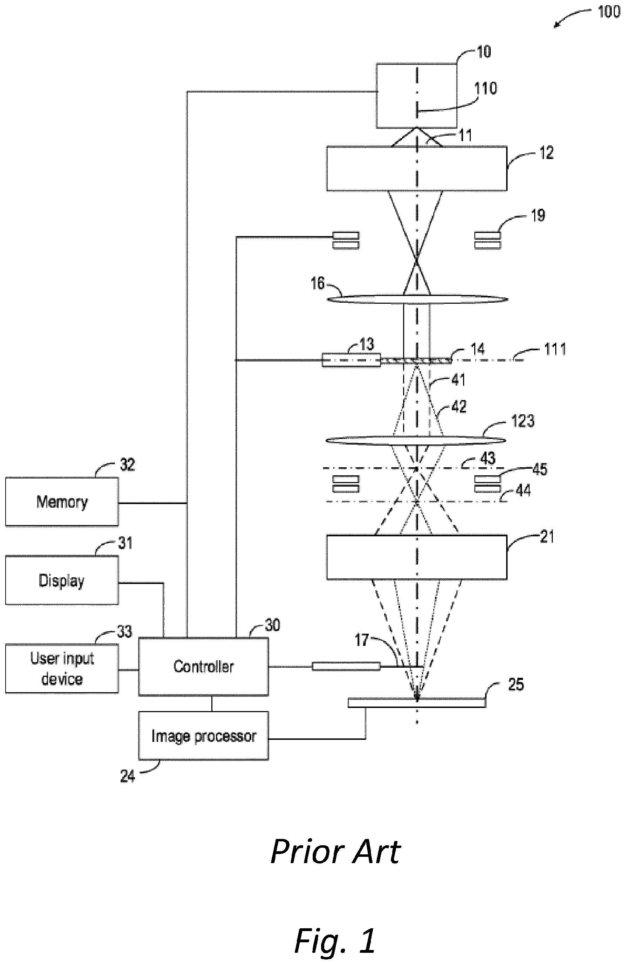

Figure 1 shows a schematic representation of a TEM system 100 in accordance with the prior art that includes an electron source 10 that emits electron beam 11 along optical axis 110, towards condenser optics 12. The electron source 10 may generate high energy electrons, that is, electrons having typical energies of between about 10 keV and 1,000 keV. The condenser optics 12 may include one or more condenser lenses and one or more apertures. Deflector 19 positioned downstream of the condenser optics 12 shifts and/or tilts the electron beam relative to the optical axis 110. Pre-sample objective lens 16 positioned downstream of the deflector 19 collimates the electron beam and directs the electron beam onto sample 14. The sample 14 may be held by sample stage 13 in a specimen plane 111. In some examples, the sample is positioned on a TEM grid attached to the sample stage. The sample stage 13 may adjust sample position by tilting the sample relative to the optical axis and/or translating the sample within the specimen plane. Unscattered and scattered electrons leaving sample 14 sequentially pass through post-sample objective lens 123 and projector system 21 and are collected by detector 25 positioned on the opposite side of sample 14 relative to electron source 10. The projection system 21 is operated differently in the imaging mode and in the diffraction mode. The detector 25 may detect the received electrons and send the signal to image processor 24 to form an image. The detector 25 may include an amplifier for amplifying the signal before sending the signal to the image processor 24. In one example, the detector 25 may be a CCD camera or a CMOS camera. In some embodiments, different detectors may be used for diffraction pattern acquisition and sample image acquisition.

Figure 1 shows the TEM system 100 operated in the SA (selected aperture) imaging mode and the SA diffraction mode (though in practice only one mode is possible at any one time). Dashed lines 41 illustrate beam path of unscattered electrons from sample 14 to detector 25 in the SA diffraction mode. Unscattered electrons are focused in the back focal plane 43 in case of parallel illumination the sample 14 while scattered electrons can form an electron diffraction (ED) pattern in this plane. In the SA diffraction mode, the projector system 21 images the back focal plane 43 of the post-sample objective lens 123 to detector 25. The beam stopper 17 can be inserted into the optical axis 110 to block the unscattered beam and protect the detector from being damaged by this intense beam while scattered electron can still reach the detector. Dashed lines 42 illustrate beam path of scattered electrons from sample 14 to detector 25 in the SA imaging mode. In the SA imaging mode, the specimen plane 111 is imaged to the SA plane 44, and the projector system 21 images the SA plane 44 to detector 25. The beam stopper 17 is retracted from the optical axis 110. In one example, a SA aperture may be inserted in the beam path. The SA aperture may be positioned in the SA plane 44. Alternatively, the condenser aperture in the condenser optics 12 may serve as beam limiting aperture. In another example, an image deflector 45 may be positioned between the sample and the detector for shifting and tilting the electrons transmitted through the sample back to the optical axis, so that the ED pattern stays centered on the detector during beam tilt and the image stays centered on the detector during beam shift. The image deflector 45 may be positioned between the back focal plane 43 and the SA plane 44. In some embodiments, the TEM system does not include the beam stopper and the detector receives the unscattered beam.

The controller 30 may control the operation of TEM system 100, either manually in response to operator instructions or automatically in accordance with computer readable instructions stored in non-transitory memory (or computer readable medium) 32. The controller 30 may include a processor and be configured to execute the computer readable instructions and control various components of the TEM system 100 in order to implement any of the methods described herein. For example, the controller may adjust the TEM system to operate in different modes by adjusting one or more apertures, the strength of the objective lens 123, the beam stopper 17, and the projector system 21. The controller 30 may adjust the beam location and/or the beam incident angle on the sample by adjusting the deflector 19. The controller 30 may adjust the electron dose rate on the sample by adjusting on or more of the settings of the electron source or the illumination optics. The controller 30 may adjust the magnification by adjusting projector system 21. The controller 30 may further be coupled to a display 31 to display notifications and/or signals detected by detector 25. The controller 30 may receive user inputs from user input device 33. The user input device 33 may include keyboard, mouse, or touchscreen.

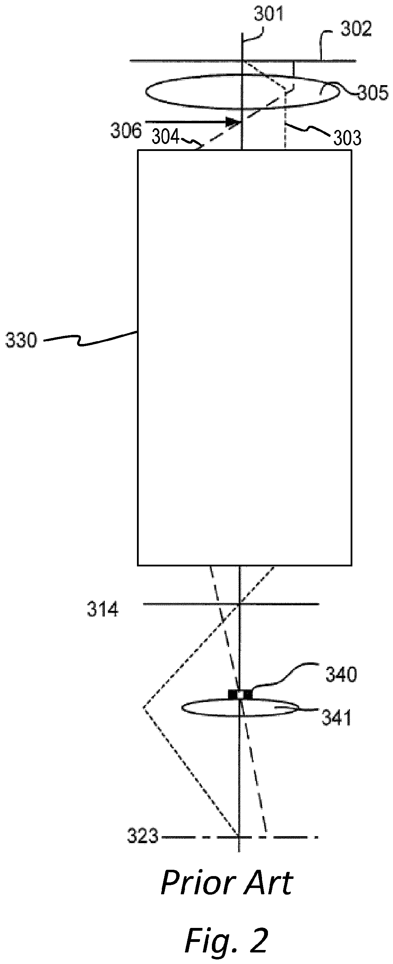

Figure 2 shows a schematic representation of part of a TEM system in accordance with the prior art comprising a correction system 330 and a phase plate 340.

The correction system 330 can be used to correct the aberrations of objective lens 305 and also to correct for some aberrations introduced by the corrector system.

A sample is positioned on the optical axis 301 in a sample plane 302 and imaged by the objective lens 305. The sample is placed near the front focal plane of the objective lens 305. Two principle rays are shown in this figure, an axial ray 303 coming under an angle from the centre of the sample where the microscope optical axis crosses the sample and a field ray 304 coming from an off-axis point from the sample, parallel to the optical axis. Ray 304 intercepts the optical axis in the back-focal plane 306 of the objective lens 305. The correction system 330 is arranged round the optical axis 301.

The last lens of correction system 330 can be used to form a diffraction plane at the position of the phase plate 340. This will result in a first image plane 314 after the corrector. An additional lens 341 can be used to transfer this image plane to the SA plane 323 in front of the projection system.

It is noted that the objective lens 305 is here (and also in Figure 1) for convenience shown as a thin lens, with the sample plane 302 outside the lens itself. Many TEMs use a thick lens as the objective lens 305, where the sample position is placed within the (magnetic) field of the objective lens 305.

In the arrangement of Figure 2, the correction system 330 is placed completely between a phase plate 340 and the objective lens 305. The correction system 330 is configured to form an image of the back-focal plane of the objective lens 305 on the phase plate.

An additional lens 341 may be used to form an image of plane 314 at plane 323, said plane acting 323 as the SA plane in front of the projection system.

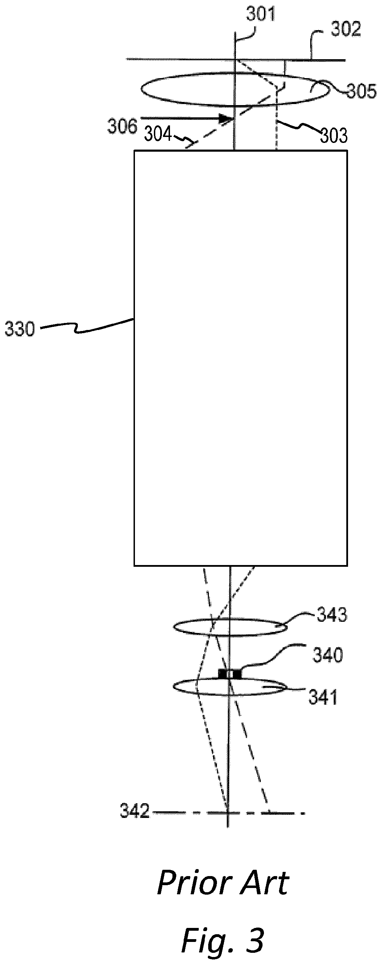

Figure 3 shows a schematic representation of part of a TEM system in accordance with the prior art the correction system 330 and phase plate 340 of Figure 2 and with an added lens 343 between correction system 330 and phase plate 340. In this arrangement, an image of the sample is formed at plane 342.

The provides a further method to vary the magnification of the back-focal plane on the plane of the phase plate.

The present disclosure recognises that a greater range of magnifications may be provided by having a range of lenses that may be selectively deployed, and more than one port for receiving the phase plate such that the phase plate may be movable between multiple locations.

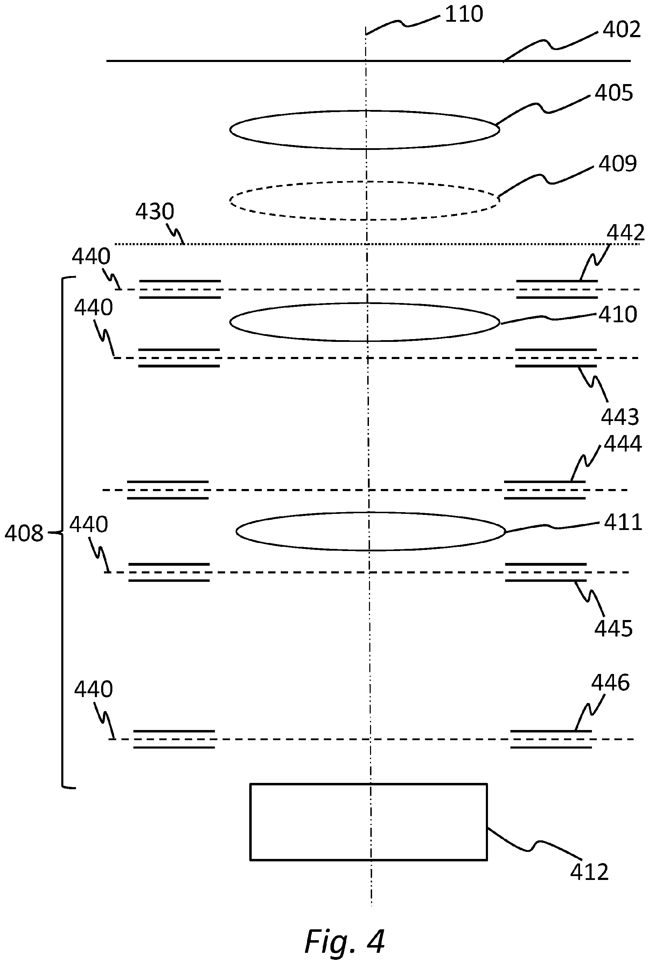

Figure 4 shows a transmission electron microscope in accordance with a first aspect of the present disclosure and including a plurality of phase plate receiving locations 442, 443, 444, 445, 446. Each phase plate receiving location 442, 443, 444, 445, 446 comprises a phase plate receiving port 442, 443, 444, 445, 446. Each phase plate receiving port 442, 443, 444, 445, 446 is configured so as to receive a phase plate receiving location 442, 443, 444, 445, 446 at the optical axis 110 at a position that is conjugate to the first diffraction plane 430. Although these are referred to as phase plate receiving ports 442, 443, 444, 445, 446, it should be noted that they may be configured to receive any wave front manipulating device 440 and might therefore be referred to as wave front manipulating device receiving ports 442, 443, 444, 445, 446.

The arrangement comprises an electron source (not shown in Figure 4) configured to produce a beam of particles along an optical axis 110. The arrangement comprises a sample holder 402 perpendicular to the optical axis 110, a primary lens 405 (also referred to as an objective lens 405) and a projection assembly 412. The arrangement further comprises an intermediate lens assembly 408 between the objective lens 405 and the projection assembly 412. The arrangement also comprises illumination optics (not shown).

The intermediate lens assembly 408 comprises a plurality of lenses 410, 411. A first lens 410 of the intermediate lens assembly 408 is located in a first lens region. A second lens 411 of the intermediate lens assembly 408 is located in a second lens region.

The projection assembly 412 occupies a projection lens region. The projection assembly 412 may comprise a plurality of lenses (not shown).

In use, a sample is positioned in the sample holder 402 in a sample plane on the optical axis 110 close to the front focal plane region of the objective lens 405. The sample is imaged by the objective lens 405 and a diffraction pattern is produced in a first diffraction plane 430. The intermediate lens assembly 408 is configured to receive the beam of electrons after leaving the primary lens and is configured to produce a magnified image of a sample present in the sample holder. The projection assembly 412 is configured to receive a magnified image of the sample.

The intermediate lens assembly 408 comprises at least some of the plurality of phase plate receiving ports 442, 443, 444, 445, 446.

Each phase plate receiving port 442, 443, 444, 445, 446 may comprise an inlet and an outlet. This is because, for laser-based wave front manipulating device 440 suitable for use with the present disclosure an outlet port is convenient for diagnosing the output laser light.

For wave front manipulating devices not based on lasers it may be more straightforward to deploy a biprism using a port having only and inlet and no outlet.

The arrangement may further comprise an additional (optional) lens 409 between the objective lens 405 and the intermediate lens assembly 408.

The additional lens 409 may be optionally deployable such that in some modes it may be deployed and in others it may not be deployed.

In the same way as not all of the lenses may be required, similarly not all of the phase plate receiving ports 442, 443, 444, 445, 446 may be required. However, the minimum number of phase plate receiving ports 442, 443, 444, 445, 446 is two, so as to allow for more than one option for the location in which to insert a phase plate 440 or other wave front manipulating device 440.

In this way, by providing more than one option for placement of the wave front manipulating device 440, with each option being spaced apart, and by an appropriate deployment of the lenses 409, 410, 411, a range of different magnifications of the first diffraction plane may be achieved, as will be explained further below.

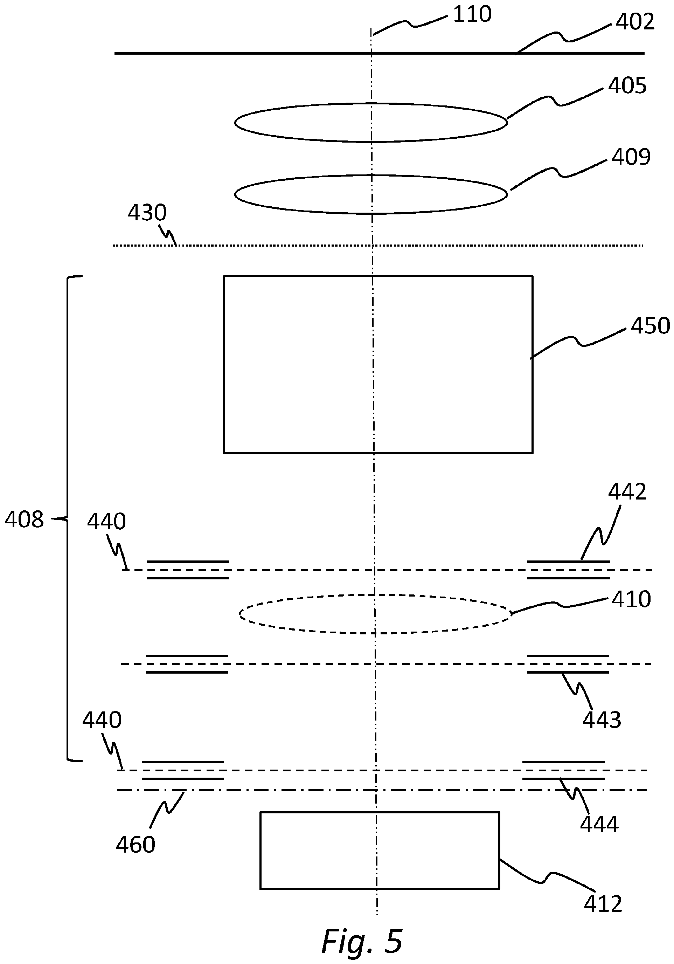

Figure 5 shows a transmission electron microscope in accordance with a second aspect of the present disclosure and including a plurality phase plate receiving ports 442, 443, 444. Many of the components of the second aspect of the present disclosure are the same as those of the first aspect of the present disclosure and so the explanation of these components will not be repeated.

In the arrangement of Figure 5, one or more of the lenses of the intermediate lens assembly 408 is/are substituted with a corrective optics assembly 450 and the additional lens 409 may be required. The arrangement of Figure 5 comprises at least two phase plate receiving ports 442, 443, 444.

In this way, by providing more than one option for placement of the phase plate 440 (or other wave front manipulating device 440), with each option being spaced apart, and by an appropriate deployment of the lenses 409, 410, or lenses in the corrective optics assembly 450, a range of different magnifications may be achieved, as will be explained further below.

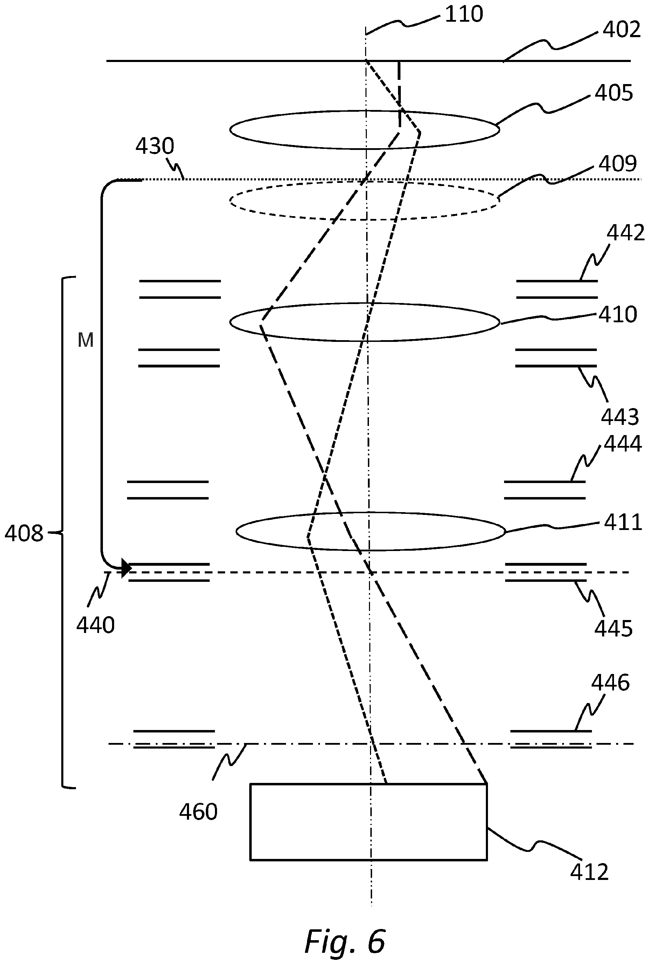

Figure 6 shows a first mode of operation of the transmission electron microscope arrangement shown in Figure 4. In this mode, the additional lens 409 is not deployed, two lenses 410, 411 of the intermediate lens assembly 408 are deployed, and a phase plate 440 is deployed in a phase plate receiving location 445 immediately following the second lens 411 of the intermediate lens assembly 408. The diffraction pattern is directed from the first diffraction plane into a second diffraction plane that is coincident with the phase plate 440 which, in this configuration, is located in phase plate receiving location 445. In this specific arrangement, small magnification of the first diffraction plane can be achieved, e.g. 2x.

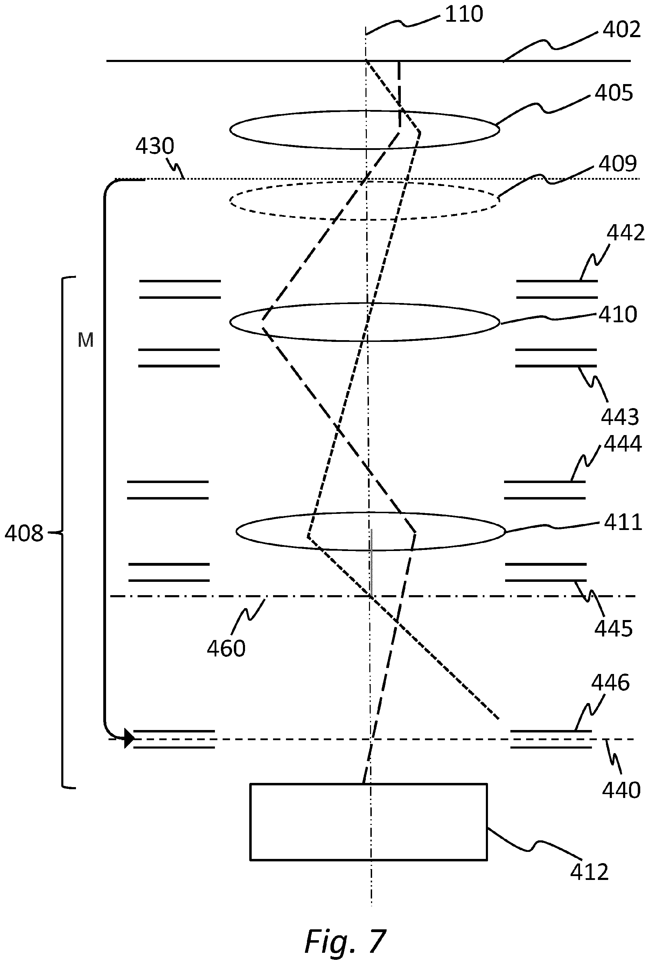

Figure 7 shows a second mode of operation of the transmission electron microscope arrangement shown in Figure 4. In this mode, the additional lens 409 is not deployed, two lenses 410, 411 of the intermediate lens assembly 408 are deployed, and a phase plate 440 (or alternative wave front manipulating device 440) is deployed in a phase plate receiving location 446 immediately prior to the projection assembly 412. The diffraction pattern is directed from the first diffraction plane into a third diffraction plane that is coincident with the phase plate 440 which, in this configuration, is located in phase plate receiving location 446. In this specific arrangement, an intermediate magnification can be achieved, e.g. 4x.

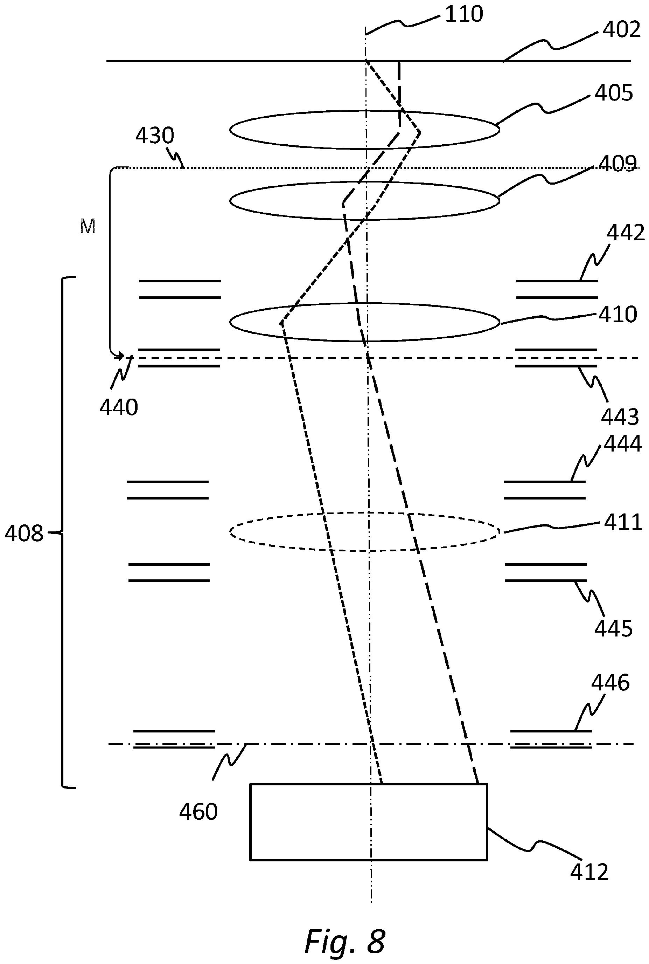

Figure 8 shows a third mode of operation of the transmission electron microscope arrangement shown in Figure 4. In this mode, the additional lens 409 is deployed, both lenses 410, 411 of the intermediate lens assembly 408 are deployed, and a phase plate 440 is deployed in a phase plate receiving location 443 immediately following the first lens 410 of the intermediate lens assembly 408. The diffraction pattern is directed from the first diffraction plane into a first diffraction plane that is coincident with the phase plate 440 which, in this configuration, is located in phase plate receiving location 443. In this specific arrangement, a large magnification can be achieved, e.g. 6x.

In this way, it is clear that the same apparatus can be straightforwardly reconfigured to achieve different levels of magnification. Furthermore, even with fewer components (e.g. without the additional lens 409, per Figures 6 and 7 still some flexibility is achievable.

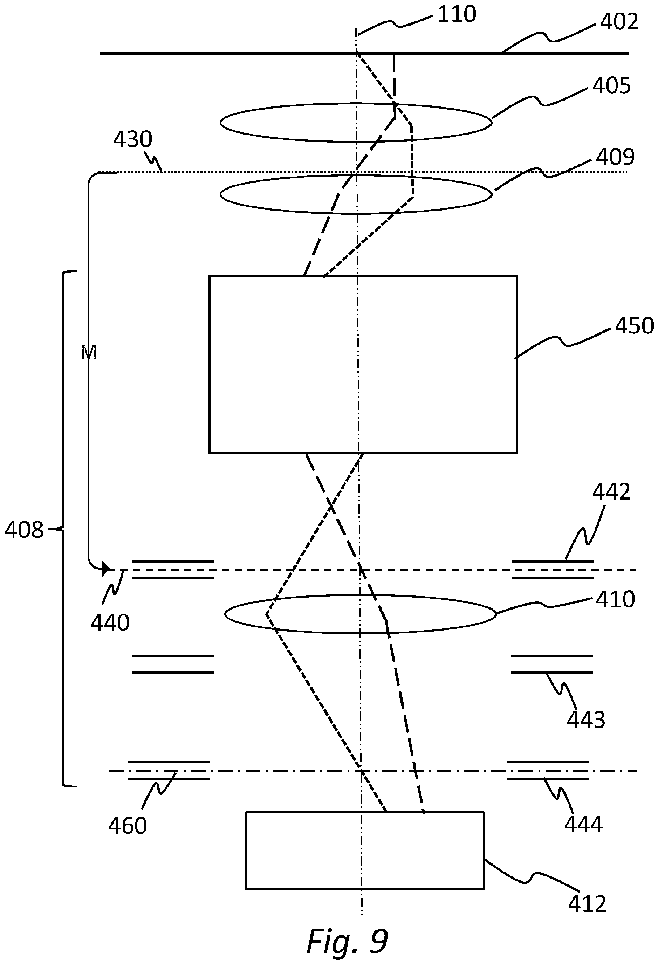

Figure 9 shows a first mode of operation of the transmission electron microscope arrangement shown in Figure 5. In this mode, the additional lens 409 is deployed, the corrective optics assembly 450 is deployed, and a lens 410 of the intermediate lens assembly 408 is deployed between the corrective optics assembly 450 and the projection assembly 412. The phase plate 440 or other wave front manipulating device 440 is located in a phase plate receiving location 442 immediately prior to the lens 410 of the intermediate lens assembly 408. In this specific arrangement, a relatively small magnification can be achieved.

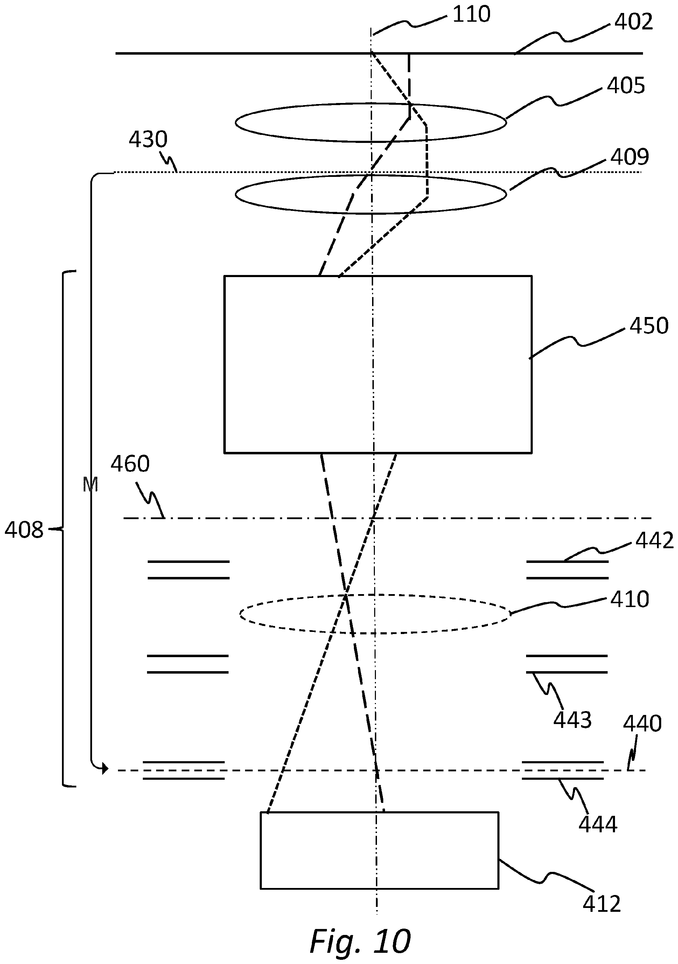

Figure 10 shows a second mode of operation of the transmission electron microscope arrangement shown in Figure 5. In this mode, the additional lens 409 is deployed, the corrective optics assembly 450 is deployed, and the phase plate 440 or other wave front manipulating device 440 is located in a phase plate receiving location 444 immediately prior to the projection assembly 412. In this specific arrangement, a relatively large magnification can be achieved.

As is clear to one skilled in the art, the specific arrangement of lenses, and optional features such as corrective optics, and the specific magnifications given are not essential to the implementation. At the heart of the disclosure is the flexibility afforded by the ability to deploy the phase plate (or alternative wave front manipulating device 440) at two or more different locations within the TEM and achieving different magnifications by deploying different combinations of lenses relative to the location in which the phase plate is deployed.

## Claims

1. A transmission electron microscope (TEM) comprising:
a sample holder configured to hold a sample;
an electron source configured to provide a beam of electrons towards the sample holder;
a primary lens configured to receive the beam of electrons after leaving the sample holder and to produce a diffraction pattern in a first diffraction plane;
an intermediate lens assembly configured to receive the beam of electrons after leaving the primary lens and to form an image of a sample present in the sample holder, wherein the intermediate lens assembly comprises, in sequence, a first lens occupying a first lens region and a second lens occupying a second lens region;
a projection assembly configured to receive the image of the sample, the projection assembly occupying a projection assembly region;
a first port in a first port plane and a second port in a second port plane, each of the first port and the second port being configured to receive a wave front manipulating device for manipulating the wave front of the beam, wherein:
each of the first port and the second port is located in a different one of: the projection assembly region, the first lens region and the second lens region; and
a controller configured to control excitation of the first lens and the second lens wherein:
in a first mode the controller is configured to control the first lens and the second lens to direct the diffraction pattern into a second diffraction plane wherein the second diffraction plane is coincident with the first port plane; and
in a second mode the controller is configured to control the first lens and the second lens to direct the diffraction pattern into a third diffraction plane wherein the third diffraction plane is coincident with the second port plane.

2. The TEM of claim 1 comprising:
a wave front manipulating device configured to be received in the first port and configured to be received in the second port.

3. The TEM of claim 1 or claim 2 wherein the first port and the second port each comprise an inlet and an outlet.

4. The TEM of any preceding claim wherein at least one of the first port and the second port is between the first lens and the second lens.

5. The TEM of any preceding claim wherein the wave front manipulating device comprises a phase manipulating device, such as a phase plate.

6. The TEM of claim 5 wherein the phase plate comprises a laser phase plate.

7. The TEM of any preceding claim wherein the primary lens is configured to immerse the sample holder in a magnetic field.

8. The TEM of any preceding claim further comprising a secondary lens between the primary lens and the intermediate lens assembly, wherein the secondary lens is configured not to immerse the sample holder in a magnetic field.

9. The TEM of any preceding claim wherein the first port is located in the first lens region.

10. The TEM of claim 9 wherein the first port is located between the primary lens and the first lens of the intermediate lens assembly.

11. The TEM of claim 9 wherein the first port is located between the first lens of the intermediate lens assembly and the second lens of the intermediate lens assembly.

12. The TEM of any of claims 1 to 8 wherein the first port is located in the second lens region.

13. The TEM of claim 12 wherein the first port is located between the first lens of the intermediate lens assembly and the second lens of the intermediate lens assembly.

14. The TEM of claim 12 wherein the first port is located between the second lens of the intermediate lens assembly and the projection assembly.

15. The TEM of any preceding claim wherein the second port is located in the projection assembly region.

16. The TEM of claim 15 wherein the second port is located between the second lens of the intermediate lens assembly and the projection assembly.

17. The TEM of any preceding claim further comprising a corrective optics assembly.

18. The TEM of claim 17 wherein the corrective optics assembly is located between the first lens of the intermediate lens assembly and the second lens of the intermediate lens assembly.

19. The TEM of claim 18 wherein the first port is located in the second lens region and the second port is located in the projection assembly region.

20. The TEM of claim 19 wherein the first port is located between the corrective optics assembly and the second lens of the intermediate lens assembly.

21. The TEM of claim 19 or claim 20 wherein the second port is located between the second lens of the intermediate lens assembly and the projection assembly.

22. The TEM of any preceding claim wherein the projection assembly comprises a first projection assembly lens and wherein the projection assembly region is a region of the first projection assembly lens.
